# EUROPÄISCHE PATENTSCHRIFT

(11) **EP 1 260 001 B1**
(45) Veröffentlichungstag und Bekanntmachung des Hinweises auf die Patenterteilung: **22.12.2004**
(21) Anmeldenummer: 01903702.7
(22) Anmeldetag: 06.02.2001
(51) Int. Cl.: H02B 1/056, H02H 1/00

(54) **SCHALTSCHRANKKLIMATISIERUNGSEINRICHTUNG**
SWITCHGEAR CABINET AIR CONDITIONING DEVICE
DISPOSITIF DE CLIMATISATION POUR ARMOIRE DE DISTRIBUTION

(30) Priorität: 17.02.2000 DE 10007270
(43) Veröffentlichungstag der Anmeldung: 27.11.2002
(73) Patentinhaber: Rittal GmbH & Co. KG, 35745 Herborn (DE)
(72) Erfinder: KREILING, Jörg, 35444 Bieberteil (DE); SEELBACH, Michael, 57258 Freudenberg (DE); HAIN, Markus, 35684 Dillenburg (DE)
(74) Vertreter: Fleck, Hermann-Josef, Dr.-Ing.
(86) Internationale Anmeldenummer: PCT/EP2001/001247
(87) Internationale Veröffentlichungsnummer: WO 2001/061808

(56) Entgegenhaltungen:
- DE-A- 19 615 469
- PATENT ABSTRACTS OF JAPAN vol. 1999, no. 12, 29. Oktober 1999 (1999-10-29) & JP 11 191927 A (TOSHIBA CORP), 13. Juli 1999 (1999-07-13)

## Beschreibung

Die Erfindung bezieht sich auf eine Schaltschrankklimatisierungseinrichtung mit mindestens einem Kühlgerät, das eine Kühlgerätesteuerung und eine mit dieser verbundene Bedienungseinrichtung aufweist.

Eine Schaltschrankklimatisierungseinrichtung dieser Art ist in der DE 196 15 469 A1 angegeben, wobei Kühlgeräte und diesen zugeordnete Kühlgerätesteuerungen über jeweilige Schnittstellen an eine gemeinsame Busstrecke angeschlossen sind. An den Bus ist auch ein Personalcomputer angeschlossen, über den die Kühlgeräte durch Ausgeben und Eingeben entsprechender Daten bedienbar sind. Die jeweiligen Kühlgerätesteuerungen sind in einer Master/Slave-Konfiguration zum Datenaustausch ausgelegt und erfordern eine entsprechende Anpassung der Kühlgerätesteuerungen und ihrer Ankopplungen an den Bus.

Eine weitere Schaltschrankklimatisierungseinrichtung ist in der DE 196 09 651 angegeben. Bei dieser bekannten Schaltschrankklimatisierungseihrichtung ist u.a. auch ein Kühlgerät vorgesehen und an eine Kühlgerätesteuerung als Teil einer zentralen Steuereinrichtung angeschlossen, die auch mit anderen Kühlkomponenten sowie mit Sensorelementen in Verbindung steht, um z.B. eine wirkungsgrad- oder energieoptimierte Steuerung der Schaltschrankklimatisierung durchzuführen. Auch Strom- oder Spannungsdetektoren können an die zentrale Steuereinrichtung angeschlossen sein. Mit dieser Steuereinrichtung sind vielfältige Überwachungs- und Steuerungsfunktionen zum Sicherstellen eines in einem jeweiligen Einsatzfall günstigen Klimatisierungsbetriebs ermöglicht, jedoch sind für die Bedienung, die insbesondere vor Ort erfolgt, Einzelkenntnisse und ein entsprechender Bedienungsaufwand erforderlich.

In Patent Abstracts of Japan, JP 11 191 927 A ist ein an ein Netzwerk angeschlossenes Versorgungssystem mit einer Anzeigeeinrichtung und einer HTML-Editiereinrichtung für Systemzustände des Versorgungssystems gezeigt. Auch ist an das Netzwerk ein Server angeschlossen und mit einer Vielzahl von allgemeinen Zwecken dienenden Browsern verbunden.

Die DE 198 08 616 A1 zeigt ein Verfahren und ein System zur Fernsteuerung und Informationsübertragung, bei dem einerseits ein Benutzerrechner mit Web-Browser und andererseits ein an das Internet angeschlossener Web-Server vorgesehen sind, an den über einen Verbindungs-Server mindestens ein Gerät, nämlich speziell eine elektronische Kamera angeschlossen ist. Der Verbindungs-Server ist über ein lokales Netz oder das Internet mit dem Web-Server verbindbar und weist andererseits ein Modem für die Schaltung einer Wählleitung zu dem Gerät auf. Auf dem Web-Server sind alle für den Verbindungsaufbau mit dem Gerät benötigten Daten zentral gehalten, während alle für den Verbindungsaufbau mit dem Gerät benötigten Daten dezentral jeweils auf einem der Verbindungs-Server gehalten werden.

Der Erfindung liegt die Aufgabe zugrunde, eine Schaltschrankklimatisierungseinrichtung der eingangs genannten Art bereit zu stellen, die bei einfacher Installation hohen Bedienungskomfort bietet.

Diese Aufgabe wird mit den Merkmalen des Anspruches 1 gelöst.

Die Ausbildung des Servers mit der Anbindung an die Kühlgerätesteuerung einerseits und die Ankopplung an das allgemein zugängliche Netzwerk andererseits ergeben zum einen eine standardisierte Schnittstelle und Zugänglichkeit mit den an beliebiger Stelle des Netzwerkes anordenbaren Personalcomputern und zum anderen einen günstigen Aufbau zum Übermitteln der Daten von der Kühlgerätesteuerung und Umsetzen der Daten für die Übertragung über das Netzwerk. In dem Server können die von der Kühlgerätesteuerung übermittelten Daten weiteren, in dem Server selbst gespeicherten, das Kühlgerät betreffenden Informationen zugeordnet werden. Mittels des Web-Browsers können die aus dem Server abgerufenen Informationen mit einer standardisierten Anbindung an das Netzwerk übersichtlich dargestellt, bearbeitet und geeignete Anweisungen an den Server und über diesen an die Kühlgerätesteuerung übermittelt werden, wodurch z.B. eine Fernüberwachung und Diagnose von Parametern sowie Einstellungen und Änderungen von Vorgabewerten über das Internet, Intranet, Ethernet oder ähnliches Netzwerk ermöglicht wird.

Für einen schnellen Datenaustausch zwischen dem Server und der Kühlgerätesteuerung ist vorgesehen, dass der Server in bidirektionaler Verbindung mit der Kühlgerätesteuerung steht. Bei der Verbindung kann es sich dabei um eine Busverbindung auf demselben Chip handeln.

Eine für den Aufbau und die Bedienung vorteilhafte Ausgestaltung besteht darin, dass eine Software des Servers und der Kühlgerätesteuerung in einem gemeinsamen Rechner eingerichtet sind, der in dem Kühlgerät integriert ist, und dass der Rechner Personalcomputer-Komponenten aufweist und wie ein solcher bedienbar ist.

Die Übersichtlichkeit und Bedienbarkeit für einen Benutzer werden dadurch verbessert, dass in dem Server Dokumentdaten zum Aufbau des Kühlgerätes und/oder dessen Bedienung gespeichert sind. Beispielsweise können als Dokumentdaten Explosionszeichnungen und eine Bedienungsanleitung gespeichert sein.

Für den einfachen Zugriff auf die von der Kühlgerätesteuerung gelieferten Informationen ist weiterhin vorteilhaft vorgesehen, dass in dem Server Alarmdaten, Zustandsdaten, statistische Daten und Temperaturdaten, die von der Kühlgerätesteuerung zugeführt werden, speicherbar sind. Auch Betriebsabläufe, mit denen auf die Arbeitsweise der Kühlgerätesteuerung eingewirkt werden kann, sind in dem Server als Programm speicherbar, wobei Änderungen von dem Personalcomputer aus vorgenommen werden können.

Eine Aufbereitung der Daten kann dadurch vorgenommen werden, dass in dem Server eine Datenverarbeitungsstufe vorgesehen ist.

Weiterhin kann eine Aufbereitung und z.B. Vorauswahl der Daten dadurch erfolgen, dass in der Kühlgerätesteuerung eine Auswertestufe zum zumindest teilweisen Auswerten und/oder Vorverarbeiten von erfassten Daten vorgesehen ist.

Eine einfache Bedienung wird dadurch unterstützt, dass der Server und/oder die Kühlgerätesteuerung mittels der Personalcomputer über das Netzwerk konfigurierbar ist/sind.

Die Übertragung der Daten wird vorteilhaft in der Weise vorgenommen, dass in der Kühlgerätesteuerung vorhandene digitale Daten auf Abruf durch den Server zu diesem übertragen werden.

Eine günstige Ausgestaltung zur Weiterleitung von in einem jeweiligen Einsatzfall wichtigen Daten besteht darin, dass die Kühlgerätesteuerung derart ausgelegt, programmiert oder programmierbar ist, dass von ihr aufgrund von in ihr vorgegebenen oder vorgebbaren Unterscheidungskriterien als wichtig erkannte Daten automatisch an den Server ausgebbar sind.

Eine Erweiterung der Steuerungs- und Überwachungsfunktionen wird dadurch erreicht, dass dem Server eine auf Software basierende Verwaltungseinrichtung zugeordnet ist, an die mindestens eine Schaltschranküberwachungs- und Steuerungseinrichtung zum Erfassen von - bezüglich den von der Kühlgerätesteuerung gelieferten - weiteren Zustandsdaten des Schaltschrankes angeschlossen oder anschließbar ist.

Dabei kann die Anordnung in der Weise vorgenommen werden, dass die Kühlgerätesteuerung über eine ihr zugeordnete Schaltschranküberwachungs- und Steuerungseinrichtung an die Verwaltungseinrichtung angeschlossen oder anschließbar ist.

Die Kühlgerätesteuerung kann mit einer Stromüberwachung für Lüfter und Kompressor, Überwachung von Temperatur, Vereisung, Kühlleistung, Hoch/Niederdruck und Phasenlage ausgestattet sein. Um eine Überprüfung oder Konfigurierung durch eine Wartungsperson auch vor Ort ohne Weiteres vornehmen zu können, besteht die Möglichkeit, Betriebsparameter und Fehlermeldungen auch in der Steuerung zu speichern. Die Steuerung kann über eine gängige Schnittstelle mit Tastern unter Anzeige über ein einfaches Display oder eine 7-Segmentanzeige vorgenommen werden. Ferner kann zusätzlich auch eine Schnittstelle zu einem lokalen Bus vorgesehen sein.

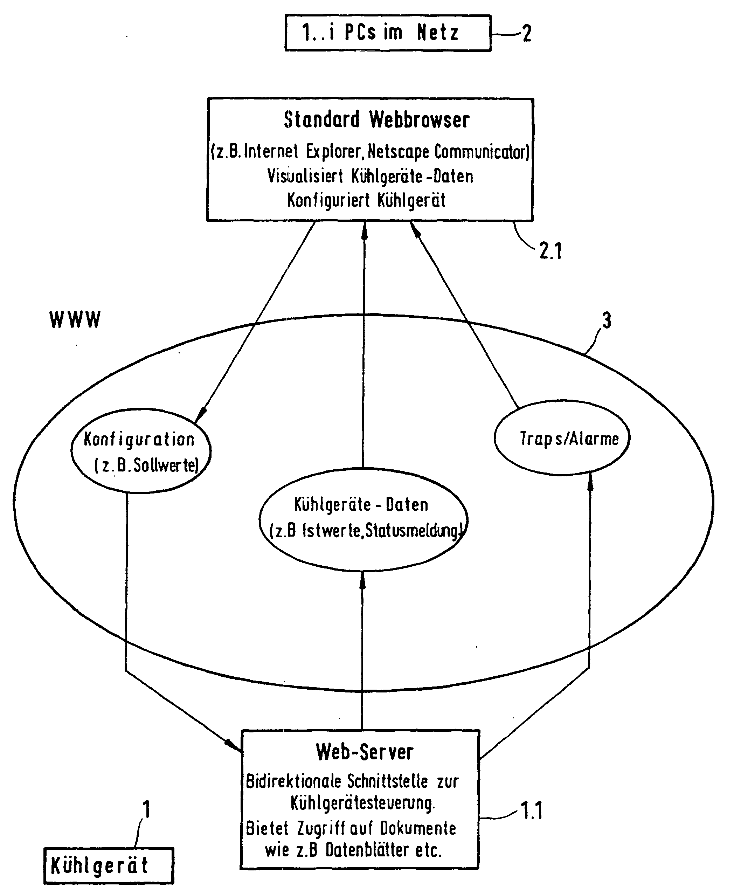

Die Erfindung wird nachfolgend anhand eines Ausführungsbeispiels unter Bezugnahme auf die Zeichnung näher erläutert.

Die Fig. zeigt eine Schaltschrankklimatisierungseinrichtung mit einem mit einer Kühlgerätesteuerung versehenen Kühlgerät 1, der beispielsweise auf einem gemeinsamen Mikrocontroller mit der Möglichkeit eines bidirektionalen Datenaustausches ein Netzwerk-Server 1.1 zugeordnet ist. Der Server 1.1 ist zum Anschluss an ein allgemein zugängliches Netzwerk 3, wie z.B. Internet, Intranet oder Ethernet ausgebildet und kann über das Netzwerk 3 mit einem an beliebiger Stelle angeordneten Rechnerarbeitsplatz, insbesondere Personalcomputer 2 mit einem zugeordneten standardisierten Web-Browser 2.1 Daten austauschen.

Beispielsweise kann von den Personalcomputern 2 aus bei übersichtlicher Darstellung mit dem Web-Browser eine Konfiguration des Servers 1.1 und/oder der Kühlgerätesteuerung einfach vorgenommen werden. Hierbei werden erfindungsgemäß Vorgabewerte eingestellt, geändert oder gelöscht sowie in dem Server gespeicherte Programme zu Betriebsabläufen oder zur Datenverarbeitung geändert oder ergänzt oder auch neue Programme eingegeben. Erfindungsgemäß werden in dem Server gespeicherte Daten bzw. Informationen, insbesondere von der Kühlgerätesteuerung übermittelte Überwachungsdaten oder in dem Server gespeicherte Dokumente, die den Aufbau und die Bedienung des Kühlgerätes betreffen, sowie Zustandsdaten des Kühlgerätes, weitere Statusmeldungen und Istwerte von dem Personalcomputer 2 aus abgerufen oder aber, sofern es sich um wichtige Daten handelt, selbstständig von dem Server 1.1 aus zu einem Personalcomputer 2 übertragen. Mittels des dem Personalcomputer 2 zugeordneten Web-Browsers 2.1 können alle von dem Server übermittelten Daten übersichtlich dargestellt werden. Dabei besteht auch die Möglichkeit, von der Kühlgerätesteuerung übermittelte aktuelle Werte in auf dem Server 1.1 vorhandene Informationen einzugliedern und gemeinsam über den Web-Browser 2.1 an dem Personalcomputer 2 übersichtlich zu visualisieren.

Da standardisierte Ankopplungen an das allgemein zugängliche Netz und entsprechend einfach verfügbare Protokolle für die Datenübertragung verwendet werden können, ist auch der Installationsaufwand gering und die Bedienung auch von ungeübtem Bedienpersonal ohne weiteres möglich. Basisprotokoll ist beispielsweise ein TCP/IP-Protokoll (Transition Control Protocol/Internet Protocol). Der Anschluss kann beispielsweise über eine Ethernet-Schnittstelle realisiert werden. Eine selbstständige Meldung bei unzulässigen Betriebszuständen kann über ein SNMP (Simple Network Management Protocol, Basis TCP /IP- und Ethernet) erfolgen.

In dem Server 1.1 des Kühlgerätes 1 können insbesondere spezifische Parameter und Daten, wie z.B. eine Ersatzteilliste, technische Daten, Explosionszeichnungen usw. hinterlegt werden. Die gespeicherten Betriebsparameter oder Fehlermeldungen werden ausgewertet und graphisch aufbereitet, in dem Server 1.1 hinterlegt und können zum Teil auch in der Kühlgerätesteuerung. gespeichert werden.

## Patentansprüche

1. Schaltschrankklimatisierungseinrichtung, die mindestens ein Kühlgerät mit einer Kühlgerätesteuerung und mindestens einen mit dieser verbundenen Personalcomputer (2) aufweist, wobei in der Kühlgerätesteuerung eine Auswertestufe zum zumindest teilweisen Auswerten und/oder Vorverarbeiten von erfassten Daten vorgesehen ist,
**dadurch gekennzeichnet,**
**dass** der Kühlgerätesteuerung ein mit dieser in bidirektionaler Verbindung stehender Server (1.1) zugeordnet ist, in dem eine Datenverarbeitungsstufe vorhanden ist und spezifische Parameter und Daten des Kühlgerätes (1) hinterlegt oder Fehlermeldungen auswertbar sind und der zum Anschluss an ein allgemein zugängliches Netzwerk (3) mit einem Netzwerkanschluss versehen ist, wobei die in dem Server (1.1) hinterlegten Daten des Kühlgerätes (1) Dokumentdaten zum Aufbau des Kühlgerätes (1) und dessen Bedienung umfassen dass eine Software des Servers (1.1) und der Kühlgerätesteuerung in einem gemeinsamen Rechner eingerichtet sind, der in dem Kühlgerät (1) integriert ist,
**dass** Meldungen bei unzulässigen Betriebszuständen selbststäntig von dem Server (1.1) aus zu dem Personal computer (2) übertragen werden, dass in der Kühlgerätesteuerung vorhandene digitale Daten auf Abruf durch den Server (1.1) zu diesem übertragbar sind, und
**dass** der Personalcomputer (2) über eine standardisierte Anbindung an das allgemein zugängliche Netzwerk (3) angeschlossen ist und einen ihm zugeordneten Web-Browser (2.1) umfasst, mittels dessen aus dem Server (1.1) über das Netzwerk (3) abgerufene Daten visualisierbar und bearbeitbar und Anweisungen an den Server (1.1) und über diesen an die Kühlgerätesteuerung übermittelbar sind und mittels dessen in dem Server (1.1) gespeicherte Programme zu Betriebsabläufen oder zur Datenverarbeitung änderbar oder ergänzbar und auch neue Programme eingebbar sind.

2. Schaltschrankklimatisierungseinrichtung nach Anspruch 1,
**dadurch gekennzeichnet,**
**dass** der Rechner Personalcomputer-Komponenten aufweist und wie ein solcher bedienbar ist.

3. Schaltschrankklimatisierungseinrichtung nach einem der vorhergehenden Ansprüche, **dadurch gekennzeichnet,**
**dass** in dem Server (1.1) Alarmdaten, Zustandsdaten, statistische Daten und Temperaturdaten, die von der Kühlgerätesteuerung zugeführt werden, speicherbar sind.

4. Schaltschrankklimatisierungseinrichtung nach einem der vorhergehenden Ansprüche, **dadurch gekennzeichnet,**
**dass** der Server (1.1) und/oder die Kühlgerätesteuerung mittels der Personalcomputer (2) über das Netzwerk (3) konfigurierbar ist/sind.

5. Schaltschrankklimatisierungseinrichtung nach einem der vorhergehenden Ansprüche, **dadurch gekennzeichnet,**
**dass** die Kühlgerätesteuerung derart ausgelegt, programmiert oder programmierbar ist, dass von ihr aufgrund von in ihr vorgegebenen oder vorgebbaren Unterscheidungskriterien als wichtig erkannte Daten, automatisch an den Server (1.1) ausgebbar sind.

6. Schaltschrankklimatisierungseinrichtung nach einem der vorhergehenden Ansprüche, **dadurch gekennzeichnet,**
**dass** dem Server (1.1) eine auf Software basierende Verwaltungseinrichtung zugeordnet ist, an die mindestens eine Schaltschranküberwachungsund Steuerungseinrichtung zum Erfassen von - bezüglich den von der Kühlgerätesteuerung gelieferten - weiteren Zustandsdaten des Schaltschrankes angeschlossen oder anschließbar ist.

7. Schaltschrankklimatisierungseinrichtung nach Anspruch 6,
**dadurch gekennzeichnet,**
**dass** die Kühlgerätesteuerung über eine ihr zugeordnete Schaltschranküberwachungs- und Steuerungseinrichtung an die Verwaltungseinrichtung angeschlossen oder anschließbar ist.

## Claims

1. Switchgear cabinet air conditioning device, which includes at least one cooling device with a cooling device controlling means and at least one personal computer (2) connected thereto, wherein an evaluating level for the at least partial evaluation and/or pre-processing of data acquired is provided in the cooling device controlling means, **characterised in that** the cooling device controlling means has associated therewith a server (1.1), which is in two-way connection with said cooling device controlling means, in which server (1.1) there is a data processing level and specific parameters and data of the cooling device (1) are deposited or error messages are evaluatable, and said server (1.1) is provided with a network connection for connection to a generally accessible network (3), wherein the data of the cooling device (1) deposited in the server (1.1) includes document data concerning the construction of the cooling device (1) and the operation of the same, **in that** a software of the server (1.1) and of the cooling device controlling means are set up in a common computer, which is incorporated in the cooling device (1), **in that** messages in the event of unreliable operating conditions are independently transferred from the server (1.1) to the personal computer (2), **in that** digital data present in the cooling device controlling means is transferable to the server (1.1) when the server (1.1) calls it up, and **in that** the personal computer (2) is connected to the generally accessible network (3) via a standardised connection and includes a web browser (2.1) associated therewith, by means of which web browser (2.1) data called up from the server (1.1) via the network (3) is displayable and processable and instructions are transmittable to the server (1.1) and, via the server (1.1), to the cooling device controlling means, and by means of which server (1.1) programs stored in the server (1.1) for operating sequences or for data processing are changeable or can be supplemented and new programs can also be input.

2. Switchgear cabinet air conditioning device according to claim 1, **characterised in that** the computer includes personal computer components and is operable as a personal computer.

3. Switchgear cabinet air conditioning device according to one of the preceding claims, **characterised in that** alarm data, status data, statistical data and temperature data, which is supplied by the cooling device controlling means, is storable in the server (1.1).

4. Switchgear cabinet air conditioning device according to one of the preceding claims, **characterised in that** the server (1.1) and/or the cooling device controlling means is configurable/are configurable via the network (3) by means of the personal computer (2).

5. Switchgear cabinet air conditioning device according to one of the preceding claims, **characterised in that** the cooling device controlling means is designed, programmed or programmable in such a manner that data it determines to be important, on account of difference criteria which are predetermined or can be set as defaults in the cooling device controlling means, can automatically be output to the server (1.1).

6. Switchgear cabinet air conditioning device according to one of the preceding claims, **characterised in that** a management device based on software is associated with the server (1.1), and at least one switchgear cabinet monitoring and controlling device is connected or is connectable to this management device for detecting further status data of the switchgear cabinet - with reference to that data supplied by the cooling device controlling means.

7. Switchgear cabinet air conditioning device according to claim 6, **characterised in that** the cooling device controlling means is connected to or is connectable to the management device via a switchgear cabinet monitoring and controlling device, which is associated therewith.

## Revendications

1. Dispositif de climatisation pour armoire de distribution qui comprend au moins un appareil de refroidissement avec une commande et au moins un ordinateur personnel (2) relié à celle-ci, sachant que l'on a prévu, dans la commande pour appareil de refroidissement, un niveau d'analyse pour l'analyse et/ou le prétraitement au moins partiels de données enregistrées, **caractérisé en ce qu'**à la commande pour appareil de refroidissement est attribué un serveur (1.1) en communication bidirectionnelle avec celle-ci, serveur dans lequel se trouve un niveau de traitement des données, des paramètres ou données spécifiques de l'appareil de refroidissement (1) sont stockés ou des messages d'erreur peuvent être analysés et qui est équipé d'un raccord de réseau pour le raccordement à un réseau (3) généralement accessible, sachant que les données de l'appareil de refroidissement (1) stockées dans le serveur (1.1) comprennent des données de document concernant le montage de l'appareil de refroidissement (1) et sa manipulation, qu'un logiciel du serveur (1.1) et un logiciel de la commande pour appareil de refroidissement sont installés dans un ordinateur commun qui est intégré dans l'appareil de refroidissement (1), que les messages sont automatiquement transmis du serveur (1.1) à l'ordinateur personnel (2) dans le cas où des états de fonctionnement non autorisés surviendraient, que les données numériques existant dans la commande pour appareil de refroidissement peuvent être transmises sur appel du serveur (1.1) à ce même serveur et **en ce que** l'ordinateur personnel (2) est raccordé par le biais d'une liaison standardisée au réseau (3) généralement accessible et comprend un navigateur web (2.1) qui lui est attribué, au moyen duquel les données appelées à partir du serveur (1.1) par le biais du réseau (3) peuvent être visualisées et traitées et au moyen duquel des instructions peuvent être transmises au serveur (1.1) et, par le biais de celui-ci, à la commande pour appareil de refroidissement et au moyen duquel des programmes, enregistrés dans le serveur (1.1), concernant des processus d'exploitation ou le traitement des données, peuvent être modifiés ou complétés ou également de nouveaux programmes peuvent être introduits.

2. Dispositif de climatisation pour armoire de distribution selon la revendication 1, **caractérisé en ce que** l'ordinateur comprend des composantes d'ordinateur personnel et les instructions indiquant comment manipuler un tel ordinateur personnel.

3. Dispositif de climatisation pour armoire de distribution selon l'une quelconque des revendications précédentes, **caractérisé en ce que**, dans le serveur (1.1), il est possible d'enregistrer des données concernant l'alerte, l'état, les statistiques et la température, lesquelles sont amenées par la commande pour appareil de refroidissement.

4. Dispositif de climatisation pour armoire de distribution selon l'une quelconque des revendications précédentes, **caractérisé en ce que** le serveur (1.1) et/ou la commande pour appareil de refroidissement peuvent être configurés au moyen de l'ordinateur personnel (2) par le biais du réseau (3).

5. Dispositif de climatisation pour armoire de distribution selon l'une quelconque des revendications précédentes, **caractérisé en ce que** la commande pour appareil de refroidissement est étudiée, programmée ou programmable, de telle sorte qu'il soit possible de transmettre automatiquement au serveur (1.1) des données reconnues par la commande comme étant importantes sur la base de critères de différenciation prédéfinis ou pouvant être prédéfinis.

6. Dispositif de climatisation pour armoire de distribution selon l'une quelconque des revendications précédentes, **caractérisé en ce qu'**est attribué au serveur (1.1) un dispositif d'administration fondé sur des logiciels, dispositif auquel sont raccordés ou raccordables au moins un dispositif de surveillance de l'armoire de distribution et un dispositif de commande pour l'enregistrement d'autres données d'état de l'armoire de distribution, en ce qui concerne les données fournies par la commande pour appareil de refroidissement.

7. Dispositif de climatisation pour armoire de distribution selon la revendication 6, **caractérisé en ce que** la commande pour appareil de refroidissement est raccordée ou raccordable au dispositif d'administration par le biais d'un dispositif de surveillance de l'armoire de distribution et d'un dispositif de commande qui lui sont attribués.
